# EUROPÄISCHE PATENTSCHRIFT

(11) **EP 1 208 583 B1**
(45) Veröffentlichungstag und Bekanntmachung des Hinweises auf die Patenterteilung: **29.04.2009**
(21) Anmeldenummer: 00947729.0
(22) Anmeldetag: 08.08.2000
(51) Int. Cl.: H01J 37/32

(54) **PLASMAREAKTOR ZUR BEHANDLUNG VON GROSSFLÄCHIGEN SUBSTRATEN**
PLASMA REACTOR FOR TREATING SUBSTRATES HAVING LARGE SURFACES
REACTEUR A PLASMA PERMETTANT DE TRAITER DES SUBSTRATS A GRANDE SURFACE

(30) Priorität: 10.08.1999 CH 146699
(43) Veröffentlichungstag der Anmeldung: 29.05.2002
(60) Teilanmeldung: 09002513.1
(73) Patentinhaber: Oerlikon Trading AG, Trübbach, 9477 Trübbach (CH)
(72) Erfinder: SCHMITT, Jacques, F-91620 La Ville du Bois (FR)
(86) Internationale Anmeldenummer: PCT/CH2000/000419
(87) Internationale Veröffentlichungsnummer: WO 2001/011658

(56) Entgegenhaltungen:
- EP-A- 0 280 074
- FR-A- 2 342 783
- GB-A- 2 261 396
- US-A- 4 425 210

## Beschreibung

Diese Erfindung bezieht sich auf einen kapazitiv gekoppelten Hochfrequenz (RF) Plasmareaktor und auf einen Prozess für die Behandlung mindestens eines Substrats in solch einem Reaktor. Im besonderen beschäftigt sich die vorliegende Erfindung mit einem kapazitiv gekoppelten (RF) Plasmareaktor für grossformatige Substrate.

Solche Reaktoren sind als "kapazitive" RF-Glimmentladungsreaktoren bekannt, bzw. als planare Plasmakapazitäten oder Parallel-Platten RF-Plasmareaktoren, oder als Kombination der oben erwähnten Begriffe.

Kapazitive RF-Plasmareaktoren werden typischerweise dazu verwendet, ein Substrat dem Prozesschritt einer Glimmentladung zu unterziehen. Verschiedene Prozesse werden benutzt, um die Natur der Substratoberfläche zu verändern. Abhängig vom Prozess und insbesondere vom in die Glimmentladung eingebrachten Gas, können die Substrateigenschaften verändert (Haftung, Benetzung), ein Dünnfilm aufgebracht (chemical vapour deposition CVD, Dioden Sputtering) oder ein anderer Dünnfilm gezielt entfernt werden (dry etching, Trockenätzverfahren).

Die unten angeführte Tabelle gibt eine vereinfachte Zusammenfassung der verschiedenen Prozesse, die in einer kapazitiven Entladung bei niedrigem Druck ausgeführt werden können.

| *Industriezweig* | *Substrat Typ* | *Prozess* | *Art des eingeleiteten Gases* |
|---|---|---|---|
| Halbleiter | Wafer bis zu 30 cm | - Oberflächen- | - Ar |
| | Durchmesser | reinigung | - SiH₄ |
| | | - PECVD | - CF₄, SF₆, Cl₂,... |
| | | - Dry etching | - O₂,.. |
| | | - Veraschen | |
| Speicherplatten | Polymer oder Glas | - Dioden Sputtering | - Ar und andere |
| | bis zu 30 cm | - PECVD | - Organometalle |
| | Durchmesser | - Oberflächen-aktivierung | - O₂, etc. |
| Flachbildschirme | Glas bis zu 1,4 m in der Diagonalen | wie bei Halbleiter | wie bei Halbleiter |
| Fensterglas Gewebebeschichtung | Glas bis zu 3 m Breite, Folie, Plastik oder Metall | - Reinigung /Aktivierung, Nitrierung, Polymer-PECVD | - Luft, Argon-Monomer, Stickstoff, ... |

Die Standard-Frequenz der in der Industrie meistverwendeten HochfrequenzGeneratoren ist 13.56 MHz. Diese Frequenz ist für die industrielle Nutzung durch internationale Fernmeldeabkommen zugelassen. Niedrigere und höhere Frequenzen waren jedoch seit den Pioniertagen der Plasmakapazitäts-Anwendungen in der Diskussion. Heutzutage gibt es einen Trend, zum Beispiel bei PECVD Anwendungen (plasma enhanced chemical vapour deposition) RF-Frequenzen über 13.56 MHz zu verwenden, wobei zum Beispiel Werte bei 27.12 MHz und 40.68 MHz favorisiert werden (Harmonische von 13.56 MHz). Daher bezieht sich diese Erfindung auf RF-Frequenzen (Bereich 1 bis 100 MHz), ist jedoch hauptsächlich relevant für den Fall höherer Frequenzen (über 10 MHz). Die Erfindung kann sogar angewendet werden bis in den Mikrowellenbereich (einige GHz).

Ein wichtiges Problem tritt bei RF-Frequenzen über 13.56 MHz im Zusammenhang mit Substraten grossen Formats (Oberfläche) auf, dergestalt, dass die Grösse des Reaktors nicht mehr vernachlässigbar ist im Verhältnis zur freien Vakuumwellenlänge der elektromagnetischen RF-Welle im Prozessbereich, wo das Plasma erzeugt wird. Dann kann die Plasmaintensität im Reaktor nicht länger homogen sein. Der physikalische Ursprung dieser Einschränkung liegt in der Tatsache, dass die RF-Welle sich entlang einer sich ausbildenden stehenden Welle (räumliche Oszillation) innerhalb des Reaktors verteilt. Andere Ungleichmässigkeiten können im Reaktor ebenfalls auftreten, zum Beispiel Inhomogenitäten, die durch das Gas hervorgerufen werden, welches für den Plasma-Prozess verwendet wird.

US 4,425,210 (Fazal) beschreibt einen mit Mittelfrequenz betriebenen Plasmaätzreaktor mit einer Reihe von Elektroden, die parallel mit Abstand zueinander angeordnet sind. Eine RF Quelle wird mit den Elektroden verbunden und mit Mittelfrequenz bis max. 111 kHz betrieben. Die zu behandelnde Substrate werden dem Feld zwischen den Elektroden ausgesetzt. Die Elektroden sind beidseitig mit dielektrischen Belägen nicht gleichförmiger Dicke versehen.

Es ist ein Ziel der Erfindung, eine Lösung zur Beseitigung, oder zumindest beträchtlichen Reduzierung einer elektromagnetischen (oder Prozess-) Inhomogenität in einem Reaktor vorzuschlagen.

Dies wird durch einen kapazitiv gekoppelten Hochfrequenz-Plasmareakter gemäß Anspruch 1 erreicht.

Ein Behandlungsprozess im Reaktor dieser Erfindung umfasst die Schritte von:
- Anordnung zumindest eines Substrats zwischen zumindest zwei Elektroden, wobei das Substrat in einer Bezugsebene ausgerichtet ist,
- Einleiten eines reaktiven Gases (oder einer Gasmischung) in einen inneren Prozessraum zwischen den beiden Elektroden,
- Anschluss eines Hochfrequenz-Generators an mindestens eine der Elektroden an einem Anschlusspunkt,
- Erzeugen einer Plasmaentladung in mindestens einem Bereich des inneren Prozessraums vor dem Substrat, so dass besagtes Substrat dem Prozessschritt der Plasmaentladung ausgesetzt wird,
- Erzeugung einer Extra-Kapazität, elektrisch in Serie mit dem Substrat und dem Plasma, wobei jene Extra-Kapazität ein Profil aufweist, und
- das Profil der Extra-Kapazität solcherart festgelegt ist, dass es eine ortsabhängige Kapazität pro Oberflächeneinheit in mindestens einer Richtung der Bezugsebene des Substrats aufweist durch eine nicht Gleichförmig Dicke der Extrakapazität.

Es muss festgehalten werden, dass eine solche Lösung allgemein gilt. Sie ist für alle Plasma Prozesse gültig, jedoch nur für bestimmte RF-Frequenzen.

Ein Verfahren gemäß des verhigenden Erfindung Zur Behandlung von Substraten in einen erfindungsgemäß Hochfrequenz-Plasmareaktor ist in Anspruch 11 definiert.

Die "massgeschneiderte Extra-Kapazität", entsprechend der oben erwähnten (wesentlich) "dielektrischen Schicht" wirkt als Bestandteil eines kapazitiven Teilers. Die kapazitiven Variationen lassen sich vorteilhaft erzielen durch eine ungleichmässige Dicke der besagten Schicht. Dergestalt wird die Extra-Kapazität ein Profil aufweisen mit nicht-planarem Verlauf entlang der Oberfläche.

Zur Kompensation einer ungleichmässigen Spannungsverteilung im Prozessraum des Reaktors wird besagte Dicke vorzugsweise folgendermassen festgelegt:
- Die sogenannte "korrigierende Schicht" ist am dicksten an jener Stelle des Prozessraums, die am weitesten vom Anschlusspunkt des Hochfrequenz-Generators an besagter Elektrode entfernt ist, wobei der Abstand gemessen wird, indem man der äusseren Elektrodenoberfläche folgt,
- und besagte Dicke vorzugsweise von besagter Stelle im Prozessraum ausgehend abnimmt, so wie der Abstand zwischen der Stelle im Prozessraum und dem Anschlusspunkt der zugehörigen Elektrode abnimmt.

Selbstverständlich muss unter dem vorgenannten "Abstand" der kürzeste aller möglichen Wege verstanden werden.

Wenn die sich ausbreitenden elektromagnetischen Wellen, die in den Prozessraum eingespeist werden, sich nahe Reaktormitte überlagern, um eine stehende Welle zu bilden und so ein Spannungsmaximum in der Umgebung der Reaktormitte auftritt, wird die Dicke der sogenannten "korrigierenden Schicht" in der Mitte grösser sein als am Rande.

Eine erfindungsgemässe Lösung für das Anpassen der sogenannten "korrigierenden Schicht" liegt darin, zumindest eine Oberfläche dieser Schicht so auszuformen, dass die Schicht eine nicht-planare äussere Oberfläche aufweist, bevorzugt eine gekrümmte, konkave Oberfläche, die dem inneren Prozessraum zugewandt ist. Eine solche "nicht planar geformte" Oberfläche kann auf verschiedenen Wegen erreicht werden.

Ein erfindungsgemäss bevorzugter Weg liegt darin, zumindest eine der Elektroden so zu formen, dass besagte Elektrode eine nicht-planare, dem Substrat zugewandte Oberfläche hat, insbesondere eine üblicherweise gekrümmte konkave Oberfläche.

Es ist ein anderes Ziel dieser Erfindung, die Zusammensetzung oder den Aufbau der sogenannten "korrigierenden Schicht" zu definieren.

In einer bevorzugten Ausführung weist besagte Schicht mindestens eine der Ausführungsmöglichkeiten feste dielektrische Schicht, gasförmige dielektrische Schicht, auf.

Wenn die Schicht als gasförmige dielektrische Schicht ausgeführt ist, wird das Gas bevorzugt mit dem inneren Prozessraum in Verbindung stehen, wo das Plasma erzeugt wird.

Ein Substrat, bestehend aus einer Platte mit nicht planar geformter äusserer Oberfläche stellt ebenfalls eine Lösung dar, um den erfindungsgemässen Reaktor mit der sogenannten "korrigierenden Schicht" auszustatten.

Ein weiteres Ziel der Erfindung liegt darin, die Anordnung des Substrats im Reaktor zu definieren. So kann das Substrat einen festen Bestandteil aufweisen, angeordnet auf Abstandselementen, die sich zwischen besagtem festen Bestandteil und einer der Elektroden befinden, wobei besagte Abstandshalter sich in erwähnter "korrigierender Schicht" befinden und unterschiedliche distanzbestimmende Abmessungen aufweisen.

Eine Schwierigkeit, die durch solche Abstandshalter hervorgerufen wird, hängt mit einer lokalen Feldstörung durch den Kontakt zwischen dem Abstandshalter und dem Substrat zusammen.

Daher wird erfindungsgemäss vorgeschlagen, dass die Abstandselemente vorzugsweise ein festes Ende aufweisen, das als Auflage für den festen Bestandteil geeignet ist, wobei das feste Ende einen umgebenden Freiraum aufweist.

Die weitere Beschreibung bezieht sich auf einen kapazitiv gekoppelten RF-Plasmareaktor, in dem die Verbesserungen durch die Erfindung die elektromagnetische Inhomogenität während des Plasma-Prozesses beträchtlich reduzieren.

Vor allem anderen bringt die elektromagnetische Ausbreitung in den meisten Prozessplasmen eine echte Einschränkung für Substrate in der Grössenordnung von oder über 0.5 m² und insbesondere über 1 m², sobald die Frequenz der RF-Quelle über 10 MHz liegt. Genauer gesagt, muss die grösste Ausdehnung des Substrats berücksichtigt werden, die dem Plasma ausgesetzt wird. Wenn das Substrat eine vorwiegend quadratische Oberfläche hat, ist die besagte "grösste Dimension" die Diagonale des Quadrats. Von daher ist jede "grösste Dimension" grösser als im wesentlichen 0.7 m kritisch.

Ein grundlegendes Problem, das von der vorliegenden Erfindung gelöst wird, liegt darin, dass aufgrund des Ausbreitungscharakters der elektromagnetischen Welle in der Plasma-Kapazität die RF-Spannung im Prozessraum nicht gleichförmig ist. Wenn eine RF-Quelle zentral an eine Elektrode angeschlossen wird, nimmt die Spannung von der Mitte zu den Rändern besagter Elektrode leicht ab.

Wie oben erwähnt, liegt ein Weg, eine (im wesentlichen) gleichförmige RF-Spannung im Plasma selbst zu erreichen, im Folgenden:
- eine Kapazität wird zwischen die Elektroden eingeführt, wobei besagte Kapazität in Reihe mit dem Plasma (und dem Substrat) im Reaktor geschaltet ist,
- diese Extra-Kapazität wirkt zusammen mit der Plasma-Kapazität selbst als Spannungsteiler, der die lokale RF-Leistungsverteilung anpasst, um Prozess - Inhomogenitäten auszugleichen, die zum Beispiel aufgrund ungleichmässiger Gaszusammensetzung, Randeffekten oder aufgrund eines Temperaturgradienten auftreten.

Weiter unten befindet sich eine detailliertere Beschreibung bevorzugter erfindungsgemässer Ausführungsformen mit Bezug auf die Zeichnungen:
Figur 1 und 2 sind zwei schematische Illustrationen eines erfindungsgemäss verbesserten Reaktors. (Figur 1 ist ein Schnitt von Figur 2 entlang der Linie I-I).
Die Figuren 3, 4, 5, 6, 7 und 8 zeigen alternative Ausführungen der internen Konfiguration eines solchen Reaktors.
Die Figuren 9, 10, 11 und 12 zeigen weitere schematische Ausführungen von typischen erfindungsgemässen Hochfrequenz-Plasmareaktoren.
Figur13 zeigt ein weiteres Beispiel eines Plasmareaktors.
Figur 14 illustriert das "Anpassungskonzept", angewandt auf eine Dickenvariation.

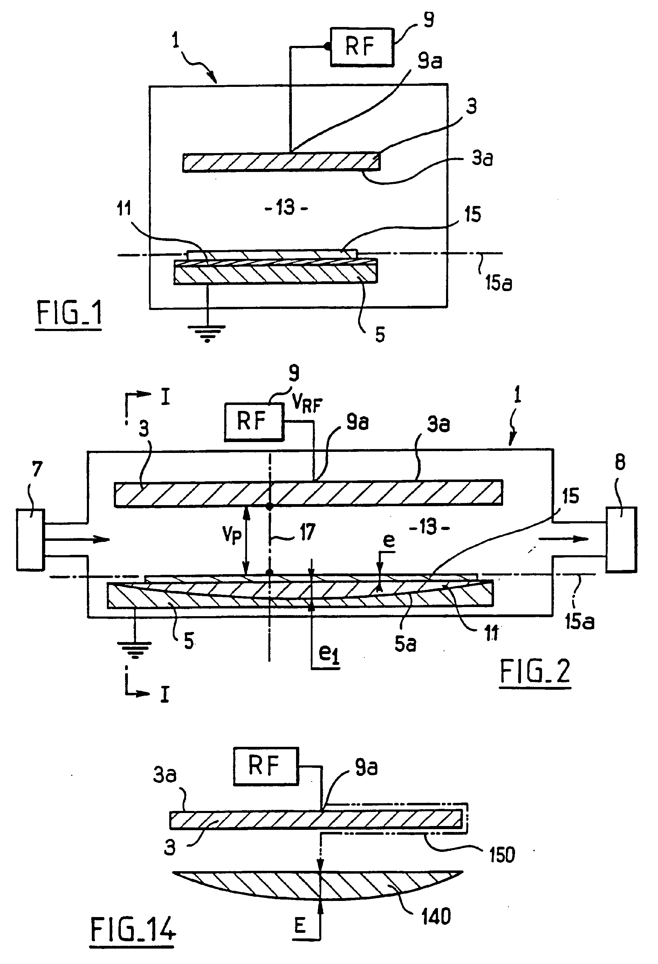

In den Figuren 1 und 2 wird der Reaktor mit 1 bezeichnet. Reaktor 1 weist zwei Metallelektroden 3, 5, mit diesbezüglicher Aussenfläche 3a, 5a auf. Diese Elektroden sind voneinander beabstandet.

Eine Gasquelle 7 versorgt den Reaktor mit einem reaktiven Gas (oder einer Gasmischung), in dem das Plasma durch eine RF-Entladung erzeugt wird (siehe Tabelle oben). Pumpvorrichtungen 8 an einem anderen Ende des Reaktors pumpen das Gas ab. Die RF-Entladung wird durch eine Hochfrequenzquelle 9 erzeugt, die an der Stelle 9a an die obere Elektrode 3 angeschlossen ist. Die Position 9 a befindet sich zentral auf der Rückseite der äusseren Oberfläche 3a dieser Elektrode.

Diese Schemazeichnungen zeigen ferner eine Extra-Kapazität 11, elektrisch in Serie mit dem Plasma 13 und einem darauf angeordneten Substrat 15.

Das Plasma 13 kann im inneren Raum (mit derselben Zahlenreferenz) beobachtet werden, der sich zwischen Elektrode 3 und Substrat 15 erstreckt.

Substrat 15 kann eine dielektrische Platte sein mit gleichmässiger Dicke e, die das untere Ende des inneren Prozessraums 13 so definiert, dass das Substrat 15 der Plasmaentladung ausgesetzt ist. Substrat 15 orientiert sich an einer allgemeinen Ebene 15a und seine Dicke e rechtwinklig zu besagter Ebene ist.

Die zwischen dem Substrat 15 und der unteren Elektrode 5 eingebrachte Extra-Kapazität 11 verursacht eine Spannungsveränderung in der Art, dass die RF-Spannung (Vₚ) über dem Plasma (z. B. entlang Linie 17, zwischen Elektrode 3 und dem Substrat 15) nur ein Bruchteil der Hochfrequenz-Spannung (V_{RF}) zwischen den Elektroden 3, 5 ist.

Es ist zu beachten, dass die Extra-Kapazität 11 materiell als dielektrische Schicht (z. B. als keramische Platte) definiert ist mit nicht-gleichmässiger Dicke e₁ in einer Richtung, die rechtwinklig ist zur vorgenannten Ebene 15 a.

Da der Anschluss der RF-Quelle auf der Elektrode 3 zentral ist und wegen der Anordnung der oben erwähnten Elemente im Reaktor (wie gezeigt in den Figuren 1 und 2), ist die Dicke e₁ der dielektrischen Platte 11 in der Mitte maximal und nimmt von besagter Mitte zum Rand hin ab, um so die elektromagnetische Ungleichförmigkeit im Prozessraum 13 auszugleichen. Auf die Weise reduziert die Anwesenheit der besagten, relativ dicken Serienkapazität die effektive Spannung über dem Plasma. Von daher muss zur Kompensation der elektromagnetischen Effekte in einem Reaktor für grossflächige Substrate wie in Figur 1 und 2 dargestellt, die Serien-Kapazität 11 in der Mitte des Reaktors ein wenig dicker sein und zum Rande hin abgeschwächt werden.

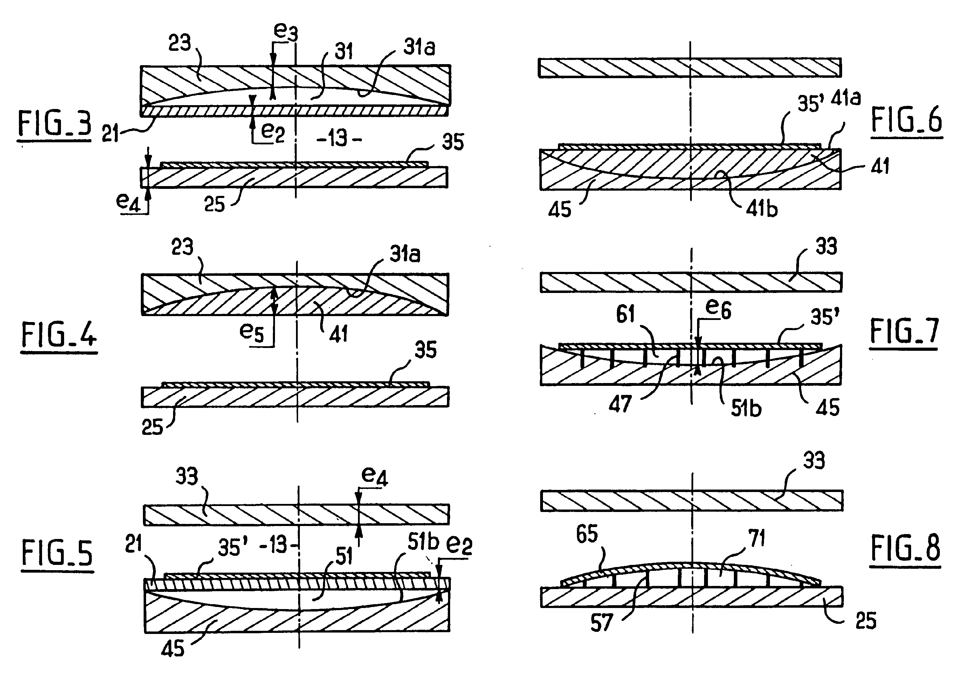

Die schematischen Illustrationen der Figuren 3 bis 8 zeigen verschiedene mögliche Konfigurationen, die eine Kompensation der Inhomogenität in einem kapazitiv gekoppelten Hochfrequenz Plasmareaktor des Typs erlauben, wie er in den Figuren 1 und 2 dargestellt ist. Es wird angemerkt, dass Kombinationen der grundlegenden Optionen, wie in den Zeichnungen 3-8 illustriert, möglich sind.

In Figur 3 ist eine flache, planare keramische Platte 21 von gleichmässiger Dicke e₂ an der oberen Elektrode 23 befestigt. Es gibt einen daran angepassten Zwischenraum 31 zwischen Metallelektrode 23 und der keramischen Platte 21.Oberhalb der anderen Elektrode 25 ist ein Substrat 35 angeordnet, das dielektrisch oder metallisch sein kann (oder elektrisch leitend auf mindestens einer seiner Oberflächen).

In den Figuren 3 bis 8 wird die Position des Anschlusses der Energiequelle (wie die RF-Quelle 9 in den Zeichnungen 1 und 2) an die zugehörige Elektrode als zentral auf der Elektrode angeordnet vorausgesetzt, und die allgemeine Geometrie des Reaktors ebenfalls wie dargestellt vorausgesetzt, so dass unter solchen Bedingungen die angepasste Schicht 31 eine rückseitige Oberfläche 31a aufweist, die gekrümmt ist mit einem konkaven regulären Profil in Richtung auf den Prozessraum 13.

Auf die Weise hat die zugehörige obere Elektrode 23 (deren innere Begrenzung, dem Prozessraum 13 zugewandt, durch die Oberfläche 31 a festgelegt wird) eine variable Dicke e₃. Die Dimension von e₃ ist am dünnsten in der Mitte der Elektrode und am dicksten an deren Rand.

Die zweite gegenüberliegende Elektrode 25 ist üblicherweise parallel zur ersten Elektrode 23 und hat eine gleichmässige Dicke e₄.

Man kann erkennen, dass die Verbindung zwischen der festen dielektrischen Platte 21 und der abgestimmten Lücke 31 keine gasdichte Verbindung ist. Auf die Weise kann das in den Prozessraum 13 eingeleitete reaktive Gas im Zwischenraum 31 zirkulieren, dessen Dicke vorzugsweise so augelegt wird, um eine Plasmaentladung darin zu vermeiden. Den "korrigierende Zwischenraum" 31 mit ergänzenden Vorrichtungen auszustatten, um besagte Plasmaentladung darin zu vermeiden, ist ebenfalls möglich.

In Figur 4 weist Elektrode 23 dasselbe innere Profil 31 a auf wie in Figur 3. Die "korrigierende Schicht" ist jetzt jedoch eine keramische Platte 41 mit variabler Stärke e₅.

In den Zeichnungen 5 bis 8 sind die Substrate 35' dielektrische Substrate.

In Figur 5 ist die obere Elektrode 33 eine planare, metallische Elektrode mit gleichförmiger Dicke e₄. Die untere Elektrode 45 entspricht der oberen Elektrode 23 von Figur 3. Die Elektrode 45 weist eine innere Oberfläche 51b auf, die eine hintere Begrenzung für die gekrümmte, konkave gasförmige "korrigierende Schicht" festlegt. Über besagter Schicht 51 ist eine dielektrische planare horizontale Platte 21 angeordnet. Die keramische Platte 21 gleichmässiger Stärke e₅ ist an ihrem Rand mit der unteren Elektrode 45 (Gegenelektrode) verbunden. Das Substrat 35' ist auf der keramischen Platte 21 angeordnet.

Da der Druck des reaktiven Gases im Reaktionsaum typischerweise zwischen 10⁻¹ bis 10³ Pa liegt, wird der Druck innerhalb des gasförmigen korrigierenden Zwischenraums im wesentlichen gleich sein wie der im Reaktionsraum. Typischerweise wird bei einem Ätzprozess der reaktive Gasdruck innerhalb der Plasmaentladungszone 13 zwischen 1 Pa und 30 Pa liegen, und zwischen 30 und 10³ Pa für einen PECVD Prozess. Demzufolge wird der Druck innerhalb des korrigierenden Zwischenraums (31, 51...) typischerweise ein niedriger Druck sein. Daher könnte man solch einen gasförmigen, dielektrischen Zwischenraum auch als "Partiaivakuum-Lücke" bezeichnen.

In Figur 6 liegt das Substrat 35' (mit gleichförmiger Dicke) auf einer festen dielektrischen Platte (Oberfläche 41 a) auf, die der keramischen Platte 41 von Figur 4 in umgekehrter Position entspricht. Die vordere, innere Oberfläche 41a der Platte 41 ist eben, ihre Rückseite 41b dagegen ist konvex und steht in direktem Kontakt mit der unteren metallischen Elektrode 45, deren innere Oberfläche hier konkav ist. Daher ist die Platte 41 eine Art "Linse".

Die Elektroden 33, 45, wie in Figur 7 dargestellt, entsprechen den Elektroden von Figur 5. Das Substrat 35', das eine gleichförmige Stärke aufweist, ist planar und parallel zur oberen metallischen Elektrode 33. Substrat 35' liegt auf kleinen Stützen 47 auf, die zwischen Elektrode 45 und dem Substrat angeordnet sind. Die nicht planare, innere, obere Fläche 51 b der Elektrode 45 ergibt zwischen Elektrode 45 und dem Substrat 35' eine gasförmige Lücke 61 mit nicht gleichförmiger Dicke e₆. Auf die Weise wirkt der Zwischenraum 61 als eine korrigierende dielektrische Schicht zur Kompensation der Prozessinhomogenität und ermöglicht, das Substrat 35' in der Plasmaentladung gleichmässig zu behandeln.

In Zeichnung 8 haben die zwei gegenüberliegenden Elektroden 25, 33 gleiche Dicke, sind planar und zueinander parallel. Die angepasste Schicht 71 wird gebildet aus einem nicht planaren Substrat 65, das auf den aufgestellten Stützen 57 angeordnet ist. Die Höhe solcher "Abstandselemente" 57 sind berechnet, um dem Substrat 65 das notwendige nicht planare Profil zu geben.

Das Entwurf von Figur 8 sollte mechanisch am vorteilhaftesten sein, weil beide Elektroden 33, 25 eben bleiben und das Profil der kleinen Lücke 71 durch die Stützen 57 festgelegt wird.

Es wird festgehalten, dass es für jeden der beschriebenen Zwecke dienlich ist, die RF-Leistung entweder an der Elektrode, an der das Substrat befestigt ist oder an der Gegenelektrode einzuspeisen.

Bezüglich der Beispielanordnungen in den Zeichnungen 1 - 8, wird weiterhin festgestellt, dass die angepasste Schicht (11, 31, 41, 51, 61, 71), vorzugsweise eine Dicke haben wird, die die Form einer Gauss'schen Glockenkurve für den Abstand Elektrode-Elektrode aufweist (auf Basis der obenerwähnten "zentralen" Anordnung). Genauer gesagt lässt sich das Profil der besagten angepassten Schicht ableiten von einer horizontal abgeschnittenen, flachen Glockenkurve, wobei namentlich die übriggebliebene "Spitze" der Glockenkurve die Form eines Querschnitts durch die korrigierende Schicht darstellt.

Die Zeichnungen 9 bis 12 zeigen andere erfindungsgemässe Ausführungen eines verbesserten, kapazitiv gekoppelten Hochfrequenz - Plasmareaktors.

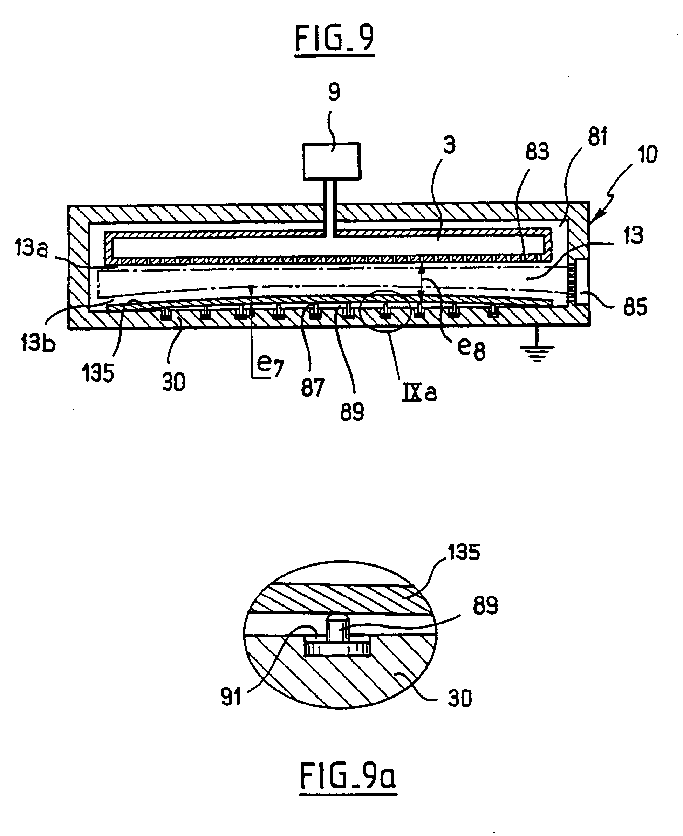

Figur 9 zeigt die unkomplizierteste Ausführung der Erfindung. Die Hochfrequenz Leistungsquelle 9 ist mit einer oberen Elektrode 3 zentral verbunden, die als "Duschkopf-Elektrode" bezeichnet wird, da sie Löcher 83 in der unteren, dem Plasma-Prozessraum 13 zugewandten Oberfläche aufweist; sie befindet sich in der inneren Kammer 81 des Reaktors 10. Die Gegenelektrode 30 wird durch die metallische äussere Wandung der Kammer 81 festgelegt. Die Zuführung des Reaktionsgases ist nicht eingezeichnet. Das Abpumpen des besagten reaktiven Gases erfolgt durch das Abgasrohr 85.

Man kann feststellen, dass alle mechanischen (materiellen) Elemente im Reaktor 10, wie in Figur 9 gezeigt, flach gehalten sind (vor allem Elektroden und Substrat 135). Das Substrat 135 jedoch (mit gleichförmiger Stärke e₇) wird gebogen durch das Aufliegen auf einer Reihe von Abstandselementen 87, die zwischen Substrat und Gegenelektrode 30 angeordnet sind. Die Abstandslemente 87 haben unterschiedliche Höhe. Das Substrat 135 wird gekrümmt aufgrund seiner eigenen Biegsamkeit. Der durchschnittliche Abstand zwischen den Stützen wird durch die Substratdicke und sein Young-Modul (Elastizitätsmodul) festgelegt.

In dieser Zusammenstellung gibt es zwei Schichten im Raum zwischen den Elektroden, deren Dicke nicht konstant (gleichförmig) ist: Der Plasma- Prozessraum 13 selbst und der "korrigierende Zwischenraum" 89 hinter dem Substrat. Obwohl dieses Beispiel keine unkomplizierte Lösung ist, ist diese Konfiguration wirksam, weil die lokal im Plasma erzeugte RF-Leistung weit mehr von einer kleinen Variation der dünnen "gasförmigen" kapazitiven Schicht hinter dem Substrat abhängt, als von der kleinen relativen Variation der Dicke e₈ des Plasmaprozessraums 13 (in Richtung der Ausdehnung von Elektrode 3).

Die "korrigierende" angepasste Schicht 89 liegt in dem Fall hinter dem Substrat. Sie ist eine angepasste gasförmige (oder Teilvakuum-) Schicht, wobei die Wortwahl "Vakuum" oder "gasförmig" lediglich benutzt wird, um die Tatsache zu betonen, dass diese Schicht eine dielektrische Konstante von 1 aufweist. Die Schicht kann Gase enthalten (die elektrische Konstante wird davon nicht betroffen).

Es besteht die Gefahr, dass die Stützen 87, seien sie metallisch oder dielektrisch, eine lokale Störung des Prozesses hervorrufen.

Tatsächlich wird an der Stützebene, wo die Serienkapazität der angepassten "korrigierenden" Schicht 89 nicht vorhanden ist, das RF-Feld lokal grösser sein. Die Störung wird sich, über eine gewisse Distanz um den Auflagepunkt herum ausbreiten. Dieser Abstand liegt im Bereich der Substratdicke e₇ plus einer "Plasmahüllendicke" (typischerweise 2-4 mm), in Figur 9 als 13a und 13b bezeichnet.

Figur 9a zeigt einen möglichen Weg, die Störung durch den Auflagepunkt auf ein erträgliches Mass zu reduzieren. Die Lösung besteht darin, jedes Abstandselement 89 mit einer kleinen Vertiefung 91 zu umgeben. Durch die Vertiefung wird die kapazitive Kopplung verringert. Durch Anpassen der Vertiefung zur exakten Kompensation sollte die lokale Störung praktisch beseitigt werden.

In Bezug auf die Erfindung zeigt diese Anordnung, dass die in der Erfindung beschriebene "korrigierende" Schicht dem vorgeschlagenen Profil "im Mittel" folgen sollte: Sehr lokale Störungen im Profil können hingenommen werden, solange die kapazitive Kopplung, gemittelt über einen Bereich weniger Millimeter, im wesentlich ununterbrochen und ordentlich angepasst bleibt.

In der Anordnung von Figur 9 ist das Substrat 135 ein dielektrisches Element. Dies ist wichtig, da jede angepasste dielektrische Schicht (so wie 89) genau innerhalb des Raumes sein muss, der durch die zwei äusserst gegenüberliegenden metallischen Schichten gebildet wird, die die "Prozesslücke" definieren. Wenn ein Substrat metallisch ist (elektrisch leitend), schirmt es den Effekt jedes darunterliegenden angepassten Leitwertes ab. Dann muss das Substrat als eine der Elektroden betrachtet werden.

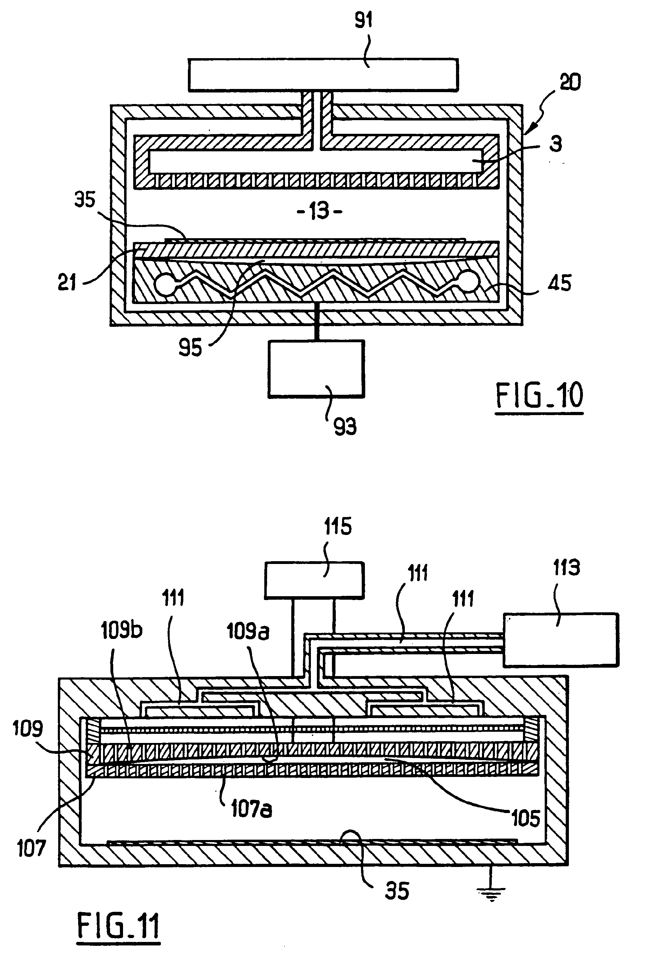

In Figur 10 ist ein in der Prozess-Industrie übliches Design illustriert. Der Reaktor 20 wird mit zwei unterschiedlich wirkenden Energiequellen gespeist: Eine RF-Hochfrequenz Quelle (über 30 MHz) und einer RF-Vorspannungsquelle 93 (unter 15 MHz). Die obere "Duschkopf-" Elektrode 3 ist mit der Hochfrequenzquelle 91 und die untere Elektrode 45 mit der Vorspannungsquelle 93 verbunden.

Eine der Quellen ist dafür vorgesehen, das Plasma zu erzeugen (in dem Fall nehmen wir an, es sei eine ziemlich hohe RF-Frequenz, durch Quelle 91). Die andere Quelle 93 wird hier als Zusatz genutzt, um ein extra Ionenbombardement auf das Substrat 35 zu ermöglichen. Typischerweise wird so eine Extra-Eingangsleistung (93) mit der substratseitigen Elektrode verbunden und bei 13.56 MHz betrieben.

Solche eine RF-Vorspannungseinrichtung wird häufig beim reaktiven Ionenätzen benutzt. Sie wird in Verbindung mit vielen Plasmatypen verwendet (so wie Mikrowellen oder Elektronenzyklotron-Resonanz).

Im Beispiel von Figur 10 existieren zwei sich gegenüberstehende Elektroden. Keine davon ist tatsächlich geerdet. Aber sogar in dieser speziellen Anordnung ist die erfindungsgemässe angepasste Kapazität (Schicht 95 mit ungleichförmiger Dicke) geeignet. Im Fall von Zeichnung 10 ist die Anordnung von Figur 5 inbegriffen.

Ein wichtiges Charakteristikum ist, dass der aktive Teil des Reaktors 20 (Plasma-Prozessraum 13, Substrat 35, ebene, planare dielektrische Platte 21 gleichförmiger Dicke und angepasster gasförmiger Zwischenraum 95 ungleichmässiger Dicke) zwischen zwei metallischen Platten (Elektroden 3, 45) liegt. Die Tatsache, ob eine geerdet ist oder nicht; die Tatsache, ob eine oder mehrere RF-Frequenzen eingespeist werden an der einen und/oder der anderen Elektrode, ist irrelevant. Die wichtigste Tatsache ist, dass sich zwischen den zwei metallischen Platten 3, 45 eine RF-Spannungsdifferenz ausbreitet. Im Beispiel von Figur 10 werden zwei RF-Frequenzen benutzt. Die Zeichnung zeigt zwei Einspeisungen (oben und unten) für die zwei RF Generatoren. Das ist nicht zwingend. Sie könnten gemeinsam von oben eingespeist werden oder von unten (obere Elektrode 3 oder untere Elektrode 45). Was hier wichtig ist, ist, dass es zwei verschiedene Frequenzen sind, eine hohe und eine niedrige Frequenz. Beide breiten sich in dem kapazitiven Reaktor aus.

Wenn, wie vorgeschlagen eine angepasste Kapazität wie 95 eingeführt wird, um die Hochfrequenz-Inhomogenität zu kompensieren, wird dies die die "niedere Frequenz" inhomogen werden lassen. Die "niederfrequente" Wellenamlitude wird dann ein leicht ausgehöhltes elektrisches Leistungsprofil liefern aufgrund der extra angepassten Kapazität im Zentrum. Mit anderen Worten macht die Anwendung des "Anpassungskonzeptes" der Erfindung nur dann einen Sinn, wenn das örtliche "Hochfrequenz" Leistungsgleichmass für den Prozess wichtiger ist als die Gleichmässigkeit der "Niederfrequenz-" Leistung.

In Figur 11 besteht die angepasste kapazitive Schicht 105 aus einem gasgefüllten Raum zwischen einer keramischen Zwischenschicht 107 und der metallischen Elektrode 109, die so bearbeitet wurde, dass deren glatte und angepasste Vertiefung (wegen der nicht planaren ineren Oberfläche 109a) der Rückseite der keramischen Platte 107 gegenübersteht. Die keramische Schicht 107 besitzt viele kleine Löcher 107a, die das reaktive Gas durchleiten, welches durch die Löcher 109b in der rückliegenden Metallelektrode strömt. Das reaktive Gas wird durch Röhren 111, die mit einer externen Gasquelle 113 verbunden sind, eingeleitet (Die Pumpvorrichtungen sind nicht eingezeichnet). Die RF-Quelle 115 ist mit Elektrode 109 wie dargestellt verbunden.

Das Design der hinteren Elektrode 109 könnte ein traditioneller "Duschkopf' sein wie Elektrode 3 in Figur 10. Eine weitere Option ist der Entwurf als kaskadierter Gasverteiler, wie in Figur 11 gezeigt.

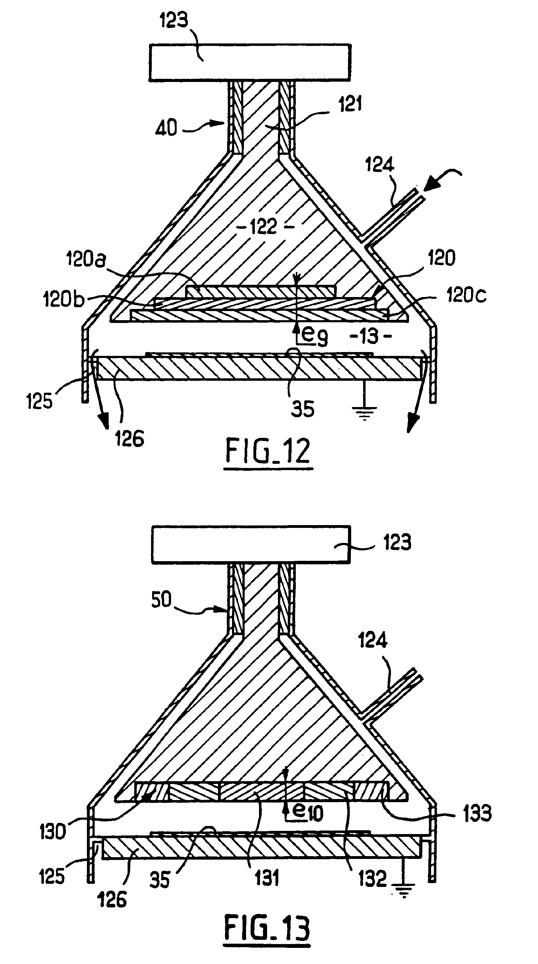

In Figur 12 ist ein kapazitiver Mikrowellen-Plasma-Reaktor als Diagramm dargestellt. Die Zeichnung zeigt einen mögliches Design, bei dem ein eher dick ausgelegter, hier als 120 bezeichnete Schichtaufbau (dessen Stärke als e₉ bezeichnet ist), dazu verwendet wird, die drastische Inhomogenität der elektromagnetischen Ausbreitung auszugleichen. Der dargestellte Reaktor 40 ist ein Reaktor zum Ätzen eher kleiner Wafer. Die Mikrowellen stammen von einem koaxialen Wellenleiter 121, der sich allmählich aufweitet im Bereich 122 ("Trompetenform"), um Reflexionen zu vermeiden. Danach erreichen die Mikrowellen die Prozesszone 13, wo die Wellen zum Zentrum des Reaktors (der zylindrisch ist) hin konvergieren sollten.

Erläuterung der Dimensionen: Das Substrat 35, angeordnet auf einer flachen Gegenelektrode 126 besitzt einen Durchmesser von etwa 10 cm. Eine 1 GHz Welle (30 cm freie Vakuumwellenlänge) wird durch den Mikrowellengenerator 123 erzeugt. Die Stärke in der Mitte der angepassten Schicht 120 (wenn aus Quartz gefertigt) sollte etwa von derselben Grösse sein wie der Raum 13 des freien Plasmas selbst.

Es wird hier vorgeschlagen, die angepasste Schicht 120 aus drei dielektrischen Platten aufzubauen, die drei Stufen festlegen (Scheiben 120a, 120b, 120c). Die Diskontinuität der Stufen sollte durch das Plasma ausgemittelt werden. Die angepasste Schicht ist vorzugsweise sehr dick und könnte als "Linse" bezeichnet werden. Die Anzahl der Scheiben, um die Linse zusammenzufügen, könnte vier oder mehr sein, wenn die idealerweise glatte Form der Linse in besserer Näherung hergestellt werden muss.

In besagter Figur 12 lässt sich feststellen, dass das reaktive Gas durch den Gaseinlass 124 eingespeist wird. Besagtes Gas wird durch eine Reihe von Schlitzen (vorzugsweise radial orientiert) durch die die Gegenelektrode 126 gepumpt und endet in einer kreisförmigen Rinne. Die Abgasvorrichtungen zum Abpumpen des reaktiven Gases aus dem Reaktionsraum zwischen den Elektroden sind nicht eingezeichnet.

In Figur 13 entspricht der Reaktor 50 dem Reaktor 40 von Figur 12 mit der Ausnahme, dass in diesem Fall die Stufenvariation der "korrigierenden" dielektrischen Schicht 130 nicht aufgrund der Veränderung der Dicke, sondern durch Verändern des Materials erzielt wird, aus dem besagte Schicht 130 sich zusammensetzt, wobei die Dicke der einzelnen Elemente gleichförmig ist. Mit anderen Worten, Schicht 130 ist eine Schicht mit variabler dielektrischer Konstante bei gleichbleibender Stärke e₁₀. Die Schicht mit niedriger dielektrischer Konstante ist die mittlere Platte 131, die konzentrisch umgeben ist von einer zweiten Platte 132 mit mittlerer dielektrischer Konstante. Die dritte äussere Platte 133 hat die höchste dielektrische Konstante.

Folglich ist der dem dicksten Teil (von Figur 12) entsprechende Anteil der angepassten Schicht 130 aus dem am wenigsten dielektrischen Material (z. B. Quartz) hergestellt, während die Zwischenschicht 132 aus einem Material wie Siliziumnitrit bestehen kann, das Material mit der höchsten dielektrischen Konstante am Rande 133 wird hier aus Alumniniumoxid gefertigt.

Das Beispiel von Figur 13 zeigt deutlich, dass eine dielektrische Schicht, deren Kapazität pro Flächeneinheit nicht gleichförmig ist auch durch eine Variation der dielektrischen Konstante besagter Schicht erhalten werden kann, wogegen deren Dicke bezogen auf die Oberfläche gleichförmig bleibt.

Aus der obigen Beschreibung und der Illustration von Figur 14 (basierend auf der Ausführung von Figur 1), muss deutlich sein, dass in jedem Fall, bei dem die Dicke der "korrigierenden" Schicht, so wie 140, dazu verwendet wird um eine beobachtete Prozess-Inhomogenität auszugleichen, die "korrigierende(n)" Schicht(en) am dicksten sein werden an der Stelle des Prozessraums (oder der gegenüberliegenden Elektrode, wie etwa 3), die am weitesten vom Elektrodenanschluss (9a) entfernt ist. Es ist festzuhalten, dass der "Weg" (bezeichnet als 150) zur Berechnung besagten "Abstands" der äusseren Oberfläche der zugehörigen Elektrode folgen muss (so wie 3a).

Besagte Dicke wird am geringsten an der entsprechenden Stelle sein, an der der obige "Abstand" am geringsten ist, und das nicht planare Profil der Schicht wird dem abnehmenden Abstand folgen.

## Patentansprüche

1. Kapazitiv gekoppelter Hochfrequenz - Plasmareaktor (1, 20), bestehend aus:
- mindestens zwei elektrisch leitenden, beabstandeten Elektroden (3, 5), mit einer äusseren Oberfläche (3a, 5a), die einen inneren Prozessraum (13) einschliessen, in dem bei Betreib des Reaktors ein Plasma ausgebildet wird,
- Gaszuführungsvorrichtungen (7) zur Versorgung des inneren Prozessraums (13) mit einem reaktiven Gas,
- mindestens einem Hochfrequenzgenerator (9), der mit mindestens einer der Elektroden (3, 5) an einem Anschlusspunkt (9a) verbunden ist,
- Vorrichtungen (8) zum Entfernen des reaktiven Gases aus dem Reaktor,
- mindestens einer Ebene (15a) zwischen den Elektroden (3, 5) zur Aufnahme eines Substrats, als Begrenzung des inneren Prozessraums
- mindestens einer dielektrischen Schicht (11) ausserhalb des inneren Prozessraums, die als Kapazität elektrisch in Serie mit einem zu prozessierenden Substrat (15) und dem Plasma geschaltet ist,
- wobei die dielektrische Schicht (11) nicht gleichförmige Flächenkapazitätsbereiche in mindestens einer Richtung der Ebene (15a) aufweist,
**dadurch gekennzeichnet, dass** die dielektrische Schicht (11)
- eine Dicke (e₁) aufweist, die nicht gleichförmig über die dielektrische Schicht und am dicksten ist an der Stelle im Prozessraum (13), die am weitesten entfernt vom Anschlusspunkt (9a) ist, an dem der Hochfrequenzgenerator mit der Elektrode verbunden ist,
- wobei diese Entfernung als kürzester Weg (150) entlang der zugehörigen äusseren Elektrodenoberfläche berechnet wird und
- wobei diese Dicke abnimmt von besagter Stelle im Prozessraum, in dem Masse, wie der Abstand zwischen dieser Stelle und dem Anschlusspunkt an der zugehörigen Elektrode abnimmt.

2. Reaktor nach Anspruch 1, mit einem weiteren Hochfrequenzgenerator (93), der mit mindestens einer der Elektroden (3, 45) an einem Anschlusspunkt (9a) verbunden ist, zur Erhöhung des Ionenbombardements auf besagtes Substrat.

3. Reaktor nach einem der Ansprüche 1 oder 2, **dadurch gekennzeichnet, dass** die dielektrische Schicht (15) zumindest eine nicht planar geformte äussere Oberfläche aufweist.

4. Reaktor nach einem der Ansprüche 1 bis 3, **dadurch gekennzeichnet, dass** zumindest eine der Elektroden eine nicht planar geformte Oberfläche aufweist, die dem Substrat zugewandt ist.

5. Reaktor nach einem der Ansprüche 1 bis 4, **dadurch gekennzeichnet, dass**:
- die dielektrische Schicht örtlich begrenzt wird durch die Oberfläche einer der Elektroden (5a, 41b, 51b), und
- die Begrenzungsoberfläche dieser Elektrode gekrümmt ist.

6. Reaktor nach einem der Ansprüche 1 bis 5, **dadurch gekennzeichnet, dass** die dielektrische Schicht aus mindestens einer festen dielektrischen Schicht, oder mindestens einer gasförmigen dielektrischen Schicht, oder einer Kombination hiervon besteht.

7. Reaktor nach einem der vorhergegangenen Ansprüche, **dadurch gekennzeichnet, dass** zwischen dem Substrat (35', 65) und einer der Elektroden (25, 45) Abstandselemente (47, 57) angeordnet sind mit unterschiedlichen distanzbestimmenden Abmessungen.

8. Reaktor nach Anspruch 7, **dadurch gekennzeichnet, dass** die Abstandshalter so ausgeführt sind, dass das Substrat (35') planar aufliegt.

9. Reaktor nach Anspruch 7, **dadurch gekennzeichnet, dass** die Abstandshalter so ausgeführt sind, dass Substrat (65) eine gekrümmte Oberfläche aufweist.

10. Reaktor nach Anspruch 7 - 9, **dadurch gekennzeichnet, dass** die Abstandselemente (89) an ihrem nicht-substratseitigen Befestigungsende von einer Vertiefung (91) umgeben sind, die geeignet ist, um zumindest teilweise die elektromagnetischen Störungen auszugleichen, die durch den Kontakt zwischen dem Abstandselement und dem Substrat hervorgerufen werden.

11. Verfahren zur Behandlung von Substraten in einem Hochfrequenz-Plasmareaktor (1, 20) gemäss Anspruch 1-10 mit folgenden Schritten:
- Anordnen von mindestens einem Substrat (15, 35', 65) zwischen zwei Elektroden (3, 5) in einer allgemeinen Ebene (15a) in einem inneren Prozessraum (13),
- Zirkulation eines reaktiven Gases innerhalb des Reaktors,
- Anschluss mindestens eines Hochfrequenzgenerators (9) an mindestens eine der Elektroden (3,5), an einem Anschlusspunkt (9a),
- Erzeugen einer Plasmaentladung in mindestens einer Zone des inneren Prozessraums (13) so dass das Substrat der Plasmaentladung ausgesetzt wird,
**dadurch gekennzeichnet, dass**
- der Hochfrequenz-Generator bei einer Frequenz über 10 MHz betrieben wird,
- das Substrat eine Oberfläche grösser als 0.5 m² aufweist,
- und die grösste Ausdehnung der Substratoberfläche, die der Plasma-Entladung ausgesetzt ist, grösser als 0.7 m ist,
um vorgegebene Verteilungsprofile zu erzeugen, insbesondere zur Kompensation einer Prozess-Inhomogenität im Reaktor.

## Claims

1. Capacitatively coupled high frequency plasma reactor (1, 20), comprising:
- at least two electrically conductive, spaced electrodes (3, 5) with an outer surface (3a, 5a), which enclose an inner process chamber (13), in which a plasma is formed on operation of the reactor,
- gas supply devices (7) to supply the inner process chamber (13) with a reactive gas,
- at least one high frequency generator (9) connected with at least one of the electrodes (3, 5) at a connection point (9a),
- devices (8) to evacuate the reactive gas from the reactor,
- at least one plane (15a) between the electrodes (3, 5) to hold a substrate, as a delimitation of the inner process chamber,
- at least one dielectric layer (11) outside the inner process chamber which is electrically connected as a capacitor in series with a substrate (15) to be processed and the plasma,
- where the dielectric layer (11) has unequal surface capacitance areas in at least one direction of the plane (15a),
**characterised in that** the dielectric layer (11)
- has a thickness (e1) which is not equal over the dielectric layer and is at its thickest at the point in the process chamber (13) which is furthest removed from the connection point (9a) at which the high frequency generator is connected with the electrode,
- wherein this distance is calculated as the shortest route (150) along the associated outer electrode surface, and
- where this thickness diminishes from said point in the process chamber to the extent that the distance decreases between this point and the connection point to the associated electrode.

2. Reactor according to claim 1, with a further high frequency generator (93) that is connected with at least one of the electrodes (3, 45) at a connection point (9a) to increase the ion bombardment on said substrate.

3. Reactor according to one of claims 1 or 2, **characterised in that** the dielectric layer (15) has at least one non-planar, formed, outer surface.

4. Reactor according to any of claims 1 to 3, **characterised in that** at least one of the electrodes has a non-planar, formed surface which faces the substrate.

5. Reactor according to any of claims 1 to 4, **characterised in that**
- the dielectric layer is locally limited by the surface of one of the electrodes (5a, 41b, 51b), and
- the delimiting surface of this electrode is curved.

6. Reactor according to any of claims 1 to 5, **characterised in that** the dielectric layer comprises at least of one solid dielectric layer or at least one gaseous dielectric layer or a combination thereof.

7. Reactor according to any of the preceding claims, **characterised in that** between the substrate (35', 65) and one of the electrodes (25, 45) are arranged spacer elements (47, 57) with different dimensions determining distance.

8. Reactor according to claim 7, **characterised in that** the spacers are designed so that the substrate (35') lies planar.

9. Reactor according to claim 7, **characterised in that** the spacers are designed so that the substrate (65) has a curved surface.

10. Reactor according to claims 7 to 9, **characterised in that** the spacer elements (89), at their fixing end which is not on the substrate side, are surrounded by a recess (91) which is suitable for compensating at least partly for the electromagnetic interference provoked by the contact between the spacer element and the substrate.

11. Method for treatment of substrates in a high frequency plasma reactor (1, 20) according to claims 1 to 10 with the following steps:
- arrangement of at least one substrate (15, 35', 65) between two electrodes (3, 5) in a general plane (15a) in an inner process chamber (13),
- circulation of a reactive gas within the reactor,
- connection of at least one high frequency generator (9) to at least one of the electrodes (3, 5) at a connection point (9a),
- generation of a plasma discharge in at least one area of the inner process chamber (13) so that the substrate is exposed to plasma discharge,
**characterised in that**:
- the high frequency generator is operated at a frequency above 10 MHz,
- the substrate has a surface area greater than 0.5 m²,
- and the greatest extension of the substrate surface exposed to the plasma discharge is greater than 0.7 m,
in order to generate specified distribution profiles, in particular to compensate for process inhomogenity in the reactor.

## Revendications

1. Réacteur (1, 20) à plasma à haute fréquence couplé de façon capacitive, comprenant :
- au moins deux électrodes conductrices (3, 5) espacées, avec une surface externe (3a, 5a) qui englobe un espace (13) de processus interne dans lequel un plasma est constitué pendant la marche du réacteur,
- des dispositifs (7) d'amenée de gaz pour alimenter l'espace (13) de processus interne en gaz réactif,
- au moins un générateur (9) à haute fréquence relié à au moins l'une des électrodes (3, 5) sur un point (9a) de raccordement,
- des dispositifs (8) pour évacuer le gaz réactif du réacteur,
- au moins un plan (15a) entre les électrodes (3, 5) pour recevoir un substrat, en tant que limitation de l'espace de processus interne,
- au moins une couche diélectrique (11) à l'extérieur de l'espace de processus interne qui, en tant que capacité, est connectée électriquement en série avec un substrat (15) à traiter et le plasma,
- la couche diélectrique (11) présentant des zones de capacité superficielles non uniformes dans au moins une direction du plan (15a),
**caractérisé en ce que** la couche diélectrique (11)
- présente une épaisseur (e₁) qui n'est pas uniforme sur la couche diélectrique et qui culmine à l'endroit qui, dans l'espace (13) de processus, est le plus éloigné du point (9a) de raccordement où le générateur à haute fréquence est relié à l'électrode,
- cet éloignement étant calculé en tant que chemin (150) le plus court le long de la surface d'électrode externe correspondante et,
- cette épaisseur diminuant dudit endroit dans l'espace de processus à mesure que diminue l'écart entre cet endroit et le point de raccordement à l'électrode correspondante.

2. Réacteur selon la revendication 1, avec un autre générateur (93) à haute fréquence relié à au moins l'une des électrodes (3, 45) sur un point (9a) de raccordement pour augmenter le bombardement ionique dudit substrat.

3. Réacteur selon l'une des revendications 1 ou 2, **caractérisé en ce que** la couche diélectrique (15) présente une surface externe formée de façon non-planaire.

4. Réacteur selon l'une des revendications 1 à 3, **caractérisé en ce qu'**au moins l'une des électrodes présente une surface externe formée de façon non-planaire, tournée vers le substrat.

5. Réacteur selon l'une des revendications 1 à 4, **caractérisé en ce que** :
- la couche diélectrique est limitée localement par la surface d'une des électrodes (5a, 41 b, 51 b), et
- la surface de limitation de cette électrode est courbée.

6. Réacteur selon l'une des revendications 1 à 5, **caractérisé en ce que** ladite couche diélectrique se compose d'au moins une couche diélectrique solide ou d'au moins une couche diélectrique gazeuse ou d'une combinaison de celles-ci.

7. Réacteur selon l'une des revendications précédentes, **caractérisé en ce que** des éléments (47, 57) d'écartement avec différentes dimensions définissant l'écartement sont disposés entre le substrat (35', 65) et l'une des électrodes (25, 45).

8. Réacteur selon la revendication 7, **caractérisé en ce que** les entretoises sont exécutées de telle sorte que le substrat (35') repose de façon planaire.

9. Réacteur selon la revendication 7, **caractérisé en ce que** les entretoises sont exécutées de telle sorte que le substrat (65) présente une surface courbée.

10. Réacteur selon les revendications 7 à 9, **caractérisé en ce que** les éléments (89) d'écartement ont leur extrémité de fixation, qui n'est pas du côté du substrat, engagée dans un creux (91) destiné à compenser au moins en partie les perturbations électromagnétiques générées par le contact entre l'élément d'écartement et le substrat.

11. Procédé pour traiter des substrats dans un réacteur (1, 20) à plasma haute fréquence selon les revendications 1 à 10, avec les étapes suivantes :
- agencement d'au moins un substrat (15, 35', 65) entre deux électrodes (3, 5) dans un plan général (15a), dans un espace (13) de processus interne,
- circulation d'un gaz réactif à l'intérieur du réacteur,
- raccordement d'au moins un générateur (9) à haute fréquence à au moins l'une des électrodes (3, 5) sur un point (9a) de raccordement,
- génération d'une décharge plasma dans au moins une zone de l'espace (13) de processus interne, de sorte que le substrat soit soumis à la décharge plasma,
**caractérisé en ce que**
- le générateur à haute fréquence est utilisé à une fréquence supérieure à 10 MHz,
- le substrat a une surface de plus de 0,5 m²,
- et la plus grande étendue de la surface du substrat, qui est soumise à la décharge plasma, est supérieure à 0,7 m,
afin de générer des profils de répartition prédéterminés, en particulier pour compenser une inhomogénéité de processus dans le réacteur.
